# EUROPEAN PATENT APPLICATION

(11) **EP 3 122 156 A1**
(43) Date of publication of application: **25.01.2017**
(21) Application number: 15765170.4
(22) Date of filing: 09.03.2015
(51) Int. Cl.: H05B 33/04, G09F 9/30, H01L 31/048, H01L 51/50, H05B 33/10

(54) **LAMINATED SHEET FOR SEALING ELECTRONIC ELEMENTS AND PRODUCTION METHOD FOR ELECTRONIC DEVICE**

(30) Priority: 19.03.2014 JP 2014057143
(71) Applicant: LINTEC Corporation, Tokyo 173-0001 (JP)
(72) Inventor: HAGIHARA, Yoshiaki, Tokyo 173-0001 (JP); TAKANO, Ken, Tokyo 173-0001 (JP)
(74) Representative: Raynor, Stuart Andrew
(86) International application number: PCT/JP2015/056881
(87) International publication number: WO 2015/141512

(57) **Abstract**

A laminated sheet (1A) for sealing electronic elements is configured to comprise: a first long release sheet (11a); a plurality of sealing materials (12) that are laminated on the first release sheet (11a) within a central area in the width direction and at different positions in the longitudinal direction; protection materials (13) that are laminated on the first release sheet (11a) at both side portions in the width direction; and a second long release sheet (11b) that is laminated on the sealing materials (12) and the protection materials (13) at the opposite sides to the first release sheet (11a). According to such a laminated sheet (1A) for sealing electronic elements, highly reliable electronic devices can be produced in an efficient manner.

## Description

### [Technical Field]

The present invention relates to a laminated sheet for sealing electronic elements which is used to seal electronic elements and relates also to a production method for electronic devices.

### [Background Art]

In recent years, organic EL (Electro Luminescence) display devices are used as display devices of electronic devices in various scenes. Such organic EL display devices are usually produced by sealing organic EL elements on a substrate with a sealing material.

For example, in the method as described in Patent Literature 1, a sheet-like sealing material having a photo-curable resin layer is attached to the entire glass substrate formed with a plurality of organic EL elements, and the photo-curable resin layer is cured by ultraviolet ray irradiation. Thereafter, the glass substrate is divided into pieces with individual organic EL elements, and organic EL display devices are obtained in which the organic EL elements are each sealed with the cured photo-curable resin layer.

Another method is described in Patent Literature 2, for example, in which a sealing film is formed on the entire substrate formed with a plurality of organic EL elements, and portions of the sealing film corresponding to terminal parts of the organic EL elements are then removed by irradiation of laser beam. Thereafter, the substrate is divided into pieces with individual organic EL elements, and organic EL display devices are obtained in which the organic EL elements are each sealed with the sealing film.

### [Prior Art Literature]

### [Patent Literature]

[Patent Literature 1] JP2004-139977A
[Patent Literature 1] JP2006-66364A

### [Summary of the Invention]

### [Problems to be solved by the Invention]

In the method as described in Patent Literature 1, portions of the sealing material corresponding to terminal parts of the organic EL elements have to be removed in a separate process. In addition, when the glass substrate is divided into pieces with individual organic EL elements, the sealing material may possibly be damaged because the sealing material is formed wholly on the glass substrate.

In the method as described in Patent Literature 2, portions of the sealing film corresponding to terminal parts of the organic EL elements are removed by irradiation of laser beam, but such a method causes a possibility that the terminal parts of the organic EL elements are damaged or a possibility that the sealing film remains at the terminal parts of the organic EL elements, which may be problematic in the reliability of organic EL display devices. In addition, the process for laser beam irradiation is required, which will increase the production cost. Further, when the substrate is divided into pieces with individual organic EL elements, the sealing film may possibly be damaged because the sealing film is formed wholly on the glass substrate.

The problems as the above are not limited to organic EL display devices, and may also be problematic in other types of display devices which require sealing, other electronic devices, e.g. solar cell modules, and the like.

The present invention has been made in consideration of such actual circumstances, and an object of the present invention is to provide means that can produce highly reliable electronic devices in an efficient manner.

### [Means for solving the Problems]

To achieve the above object, according to a first aspect of the present invention, there is provided a laminated sheet for sealing electronic elements, the laminated sheet comprising: a long release sheet; and a plurality of sealing materials laminated on the long release sheet at different positions, the sealing materials having a shape corresponding to that of the electronic elements as objects to be sealed (Invention 1). As used in the present description, the term "sheet" encompasses the concept of a tape.

According to the above invention (Invention 1), the electronic elements can be sealed using the sealing materials which may be formed in a shape corresponding to that of the electronic elements. Therefore, it is not required to remove portions of the sealing materials corresponding to the terminal parts of electronic elements such as organic EL elements, for example, and it is thus possible to prevent the possibility that the terminal parts of electronic elements are damaged due to work for the removal, and/or the possibility that the sealing materials remain at the terminal parts of electronic elements. It is also possible to prevent the possibility that the sealing materials are damaged when the plurality of electronic elements sealed on the substrate is divided into individual electronic elements. Thus, according to the above invention (Invention 1), highly reliable electronic devices can be produced in an efficient manner.

In the above invention (Invention 1), it is preferred that protection materials are provided at both side portions in a width direction of the long release sheet, and the sealing materials are provided on the long release sheet at different positions than those of the protection materials (Invention 2).

In the above invention (Invention 2), it is preferred that the protection materials have a thickness that is equal to or thicker than a thickness of the sealing materials (Invention 3).

In the above invention (Invention 2, 3), it is preferred that the protection materials are composed of the same material as that of the sealing materials (Invention 4).

In the above invention (Invention 1), gas barrier films may be laminated on the sealing materials at opposite sides to the release sheet, wherein the gas barrier films have a shape corresponding to that of the electronic elements as objects to be sealed (Invention 5).

In the above invention (Invention 5), it is preferred that protection materials are provided at both side portions in a width direction of the long release sheet, and laminates of the sealing materials and the gas barrier films are provided on the long release sheet at different positions than those of the protection materials (Invention 6).

In the above invention (Invention 6), it is preferred that the protection materials have a thickness that is equal to or thicker than a thickness of the laminates of the sealing materials and the gas barrier films (Invention 7).

In the above invention (Invention 6, 7), it is preferred that the protection materials are composed of the same materials as those of the laminates of the sealing materials and the gas barrier films (Invention 8).

In the above invention (Invention 1 to 4), it is preferred that a second long release sheet is laminated on the sealing materials at opposite sides to the release sheet (Invention 9).

In the above invention (Invention 1 to 9), it is preferred that the plurality of sealing materials are provided at positions at least in a longitudinal direction of the long release sheet (Invention 10).

In the above invention (Invention 10), the plurality of sealing materials may be provided at positions also in a width direction of the long release sheet (Invention 11).

In the above invention (Invention 1 to 11), it is preferred that the electronic elements as objects to be sealed are organic EL elements (Invention 12).

In the above invention (Invention 1 to 12), it is preferred that the sealing materials are composed of at least one type selected from the group consisting of acid-modified polyolefin-based resin, silane-modified polyolefin-based resin, ionomer, ethylene-(meth)acrylic acid copolymer, and rubber-based resin (Invention 13).

In the above invention (Invention 1 to 13), it is preferred that the laminates of the sealing materials and the gas barrier films have a moisture vapor transmission rate of 20 g/(m²·day) or less under an environment of a temperature of 40°C and a relative humidity of 90% RH in terms of a thickness of 50 µm (Invention 14).

According to a second aspect of the present invention, there is provided a production method for the above laminated sheet for sealing electronic elements (Invention 4), the production method comprising: forming a sealing material layer on one surface of the long release sheet, the sealing material layer having approximately the same size as that of the release sheet and comprising a material that constitutes the sealing materials; and half cutting the sealing material layer to remove an unnecessary portion so that the sealing materials and the protection materials are formed (Invention 15).

According to a third aspect of the present invention, there is provided a production method for the above laminated sheet for sealing electronic elements (Invention 8), the production method comprising: forming a sealing material layer and a gas barrier material layer on one surface of the long release sheet so that the sealing material layer and the gas barrier material layer are laminated in this order, the sealing material layer and the gas barrier material layer having approximately the same size as that of the release sheet, the sealing material layer comprising a material that constitutes the sealing materials, the gas barrier material layer comprising a material that constitutes the gas barrier films; and half cutting the gas barrier material layer and the sealing material layer to remove an unnecessary portion so that the laminates of the sealing materials and the gas barrier films and the protection materials are formed (Invention 16).

According to a fourth aspect of the present invention, there is provided a production method for electronic devices, comprising: laminating gas barrier films on the sealing materials of the above laminated sheet for sealing electronic elements (Invention 1 to 4) at opposite sides to the release sheet, the gas barrier films having a shape corresponding to that of the electronic elements as objects to be sealed; releasing laminates of the sealing materials and the gas barrier films from the release sheet; and causing the laminates of the sealing materials and the gas barrier films to overlap the electronic elements as objects to be sealed so that the sealing materials come into contact with the electronic elements and sealing the electronic elements (Invention 17).

According to a fifth aspect of the present invention, there is provided a production method for electronic devices, comprising: causing the sealing materials of the above laminated sheet for sealing electronic elements (Invention 1 to 4) to overlap the electronic elements as objects to be sealed; removing the release sheet from the sealing materials at any stage; laminating gas barrier films on the sealing materials at opposite sides to the electronic elements, the gas barrier films having a shape corresponding to that of the electronic elements as objects to be sealed; and sealing the electronic elements (Invention 18).

According to a sixth aspect of the present invention, there is provided a production method for electronic devices, comprising: preparing a gas barrier film-laminated sheet configured such that a plurality of gas barrier films are laminated on a long support sheet in the same arrangement as that of the sealing materials on the long release sheet of the above laminated sheet for sealing electronic elements (Invention 1 to 4), the gas barrier films having a shape corresponding to that of the electronic elements as objects to be sealed; laminating the sealing materials on the long release sheet of the laminated sheet for sealing electronic elements and the gas barrier films on the long support sheet of the gas barrier film-laminated sheet with each other; removing the release sheet from the sealing materials; causing laminates of the gas barrier films and the sealing materials on the support sheet to overlap the electronic elements as objects to be sealed so that the sealing materials come into contact with the electronic elements and sealing the electronic elements; and removing the support sheet from the gas barrier films at any stage (Invention 19).

According to a seventh aspect of the present invention, there is provided a production method for electronic devices, comprising: laminating a long gas barrier film on the sealing materials of the above laminated sheet for sealing electronic elements (Invention 1 to 4) at opposite sides to the release sheet; removing the release sheet from the sealing materials; causing the sealing materials on the long gas barrier film to overlap the electronic elements and sealing the electronic elements; and cutting the long gas barrier film into a shape corresponding to that of the electronic elements and removing an unnecessary portion (Invention 20).

According to an eighth aspect of the present invention, there is provided a production method for electronic devices, comprising: releasing laminates of the sealing materials and the gas barrier films of the above laminated sheet for sealing electronic elements (Invention 5 to 8) from the release sheet; and causing the laminates of the sealing materials and the gas barrier films to overlap the electronic elements as objects to be sealed so that the sealing materials come into contact with the electronic elements and sealing the electronic elements (Invention 21).

### [Advantageous Effect of the Invention]

According to the laminated sheet for sealing electronic elements and the production method for electronic devices of the present invention, highly reliable electronic devices can be produced in an efficient manner.

### [Brief Description of Drawings]

FIG. 1 is a perspective view of a laminated sheet for sealing electronic elements according to a first embodiment of the present invention.
FIG. 2 (a) is a plan view of the laminated sheet for sealing electronic elements according to the first embodiment of the present invention, and FIG. 2 (b) is a cross-sectional view (A-A cross-sectional view in (a)) of the laminated sheet for sealing electronic elements.
FIG. 3 is a perspective view of a laminated sheet for sealing electronic elements according to a second embodiment of the present invention.
FIG. 4 (a) is a plan view of the laminated sheet for sealing electronic elements according to the second embodiment of the present invention, and FIG. 4(b) is a cross-sectional view (B-B cross-sectional view in (a)) of the laminated sheet for sealing electronic elements.
FIG. 5 is a plan view of a laminated sheet for sealing electronic elements according to another embodiment of the present invention.
FIGS. 6(a) to 6(d) are views for explaining a production method for electronic devices according to an embodiment of the present invention.
FIGS. 7(a) to 7(d) are views for explaining a production method for electronic devices according to another embodiment of the present invention.
FIGS. 8(a) to 8(d) are views for explaining a production method for electronic devices according to another embodiment of the present invention.
FIGS. 9(a) to 9(e) are views for explaining a production method for electronic devices according to another embodiment of the present invention.
FIGS. 10(a) to 10(c) are views for explaining a production method for electronic devices according to another embodiment of the present invention.

### [Embodiments for Carrying out the Invention]

Hereinafter, embodiments of the present invention will be described.

In the embodiments of the present invention, electronic elements are objects to be sealed. The types of electronic elements are not particularly limited, provided that they can be sealing subjects, and examples thereof include organic EL elements, liquid crystal elements, light-emitting diodes (LED elements), elements for electronic paper, and solar cell elements. Electronic devices produced in the embodiments of the present invention may be those obtained by sealing electronic elements as the above, and examples thereof include modules for display devices and solar cell modules.

### <First Embodiment>

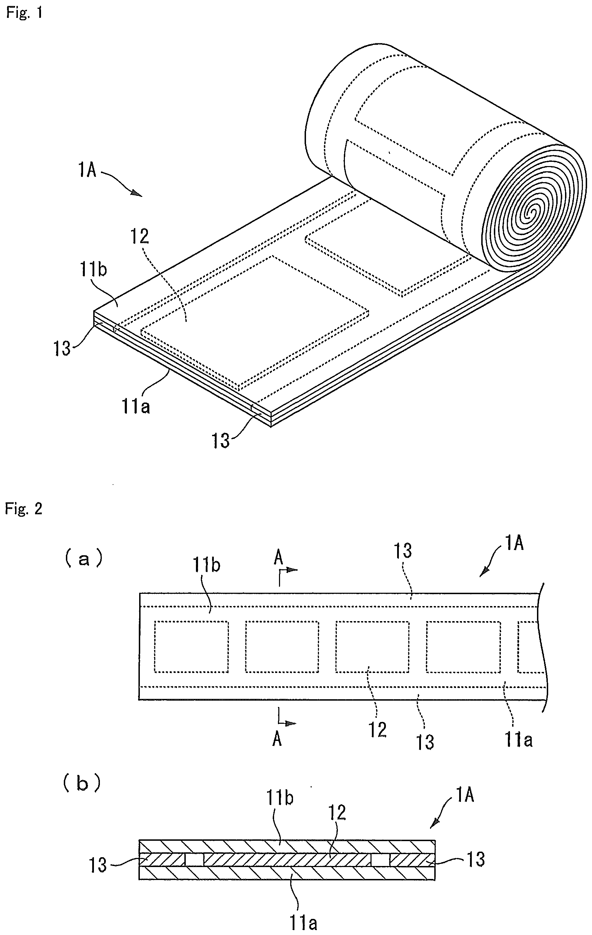

As shown in FIG. 1 and FIG. 2, the laminated sheet 1A for sealing electronic elements according to a first embodiment of the present invention may be configured to comprise: a first long release sheet 11a; a plurality of sealing materials 12 that are laminated on the first release sheet 11a within a central area in the width direction and at different positions in the longitudinal direction; protection materials 13 that are laminated on the first release sheet 11a at both side portions in the width direction; and a second long release sheet 11b that is laminated on the sealing materials 12 and the protection materials 13 at the opposite sides to the first release sheet 11a. As used herein, the term "long" refers to a length ten times the width or more.

The laminated sheet 1A for sealing electronic elements according to the present embodiment is long, and may usually be wound up into a roll-like shape and used while being unreeled from the roll (see FIG. 1).

### (1) Sealing Materials

In the laminated sheet 1A for sealing electronic elements according to the present embodiment, the sealing materials 12 have a shape corresponding to that of electronic elements as objects to be sealed. Here, the "shape corresponding to that of electronic elements" may preferably be a shape that has a sufficient size for the electronic elements to be sealed and does not require removal of the sealing materials 12 after sealing. When electronic elements are sealed with the sealing materials 12 having such a shape, it is not required to remove portions of the sealing materials corresponding to the terminal parts of electronic elements such as organic EL elements, for example, so that the process can be simplified, and it is thus possible to prevent the possibility that the terminal parts of electronic elements are damaged due to work for the removal, and/or the possibility that the sealing materials remain at the terminal parts of electronic elements. It is also possible to prevent the possibility that the sealing materials are damaged when the plurality of electronic elements sealed on the substrate is divided into individual electronic elements. Therefore, according to the laminated sheet 1A for sealing electronic elements of the present embodiment, highly reliable electronic devices can be produced in an efficient manner.

In the present embodiment, the sealing materials 12 may be in a rectangular shape in the plan view, but the shape of the sealing materials 12 is not limited thereto and can be a desired shape in accordance with the shape of the electronic elements as objects to be sealed. For example, the sealing materials 12 may be in a circular shape, in a desired polygonal shape, or in a shape in which a part or parts are cut out from such a shape, in the plan view.

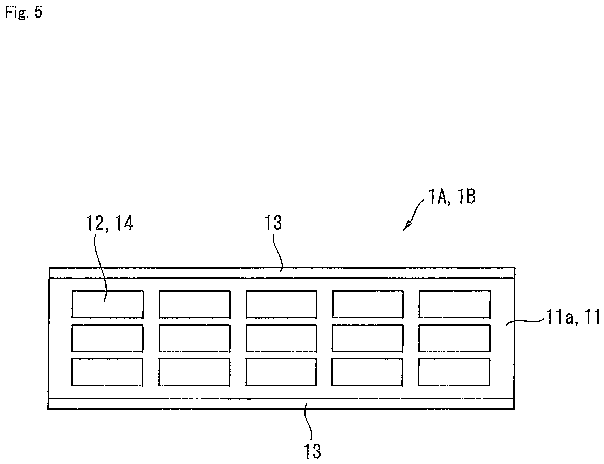

In the present embodiment, the plurality of sealing materials 12 may be provided at successive positions only in the longitudinal direction of the laminated sheet 1A for sealing electronic elements, but are not limited thereto. For example, as shown in FIG. 5, the plurality of sealing materials 12 may be provided not only at positions in the longitudinal direction of the laminated sheet 1A for sealing electronic elements but also at positions in the width direction.

The material that constitutes the sealing materials 12 may be appropriately selected in accordance with the type of electronic elements as objects to be sealed, and may comprise a single layer or multiple layers. Thermoplastic resin, thermoset resin, energy ray curable resin or the like may usually be used as the material that constitutes the sealing materials 12.

Examples of the thermoplastic resin include acid-modified polyolefin-based resin, silane-modified polyolefin-based resin, ionomer, ethylene-vinyl acetate copolymer, ethylene-(meth)acrylic acid copolymer, ethylene-(meth)acrylic ester copolymer, polyester-based resin, polyurethane-based resin, polyester-urethane-based resin, acrylic-based resin, amide-based resin, styrene-based resin, silane-based resin, and rubber-based resin. Among them, acid-modified polyolefin-based resin, silane-modified polyolefin-based resin, ionomer, ethylene-(meth)acrylic acid copolymer, and rubber-based resin are preferred because these have a high adhesion force and a relatively low moisture vapor transmission rate. One type thereof may be used alone, or two or more types may be used in combination. As used in the present description, the (meth) acrylic acid means both the acrylic acid and the methacrylic acid. The same applies to other similar terms.

The thickness of the sealing materials 12 may be a thickness that allows sealing of electronic elements as objects to be sealed, and may appropriately be determined in accordance with the thickness and shape of the electronic elements. In general, the thickness of the sealing materials 12 may preferably be 1 to 500 µm, particularly preferably 5 to 300 µm, and further preferably 10 to 100 µm.

The adhesion force of the sealing materials 12 to a glass plate (soda-lime glass) may preferably be 3 N/25 mm or more, particularly preferably 5 N/25 mm or more, and further preferably 10 N/25 mm or more. When the adhesion force is within the above range, the substrate such as a glass plate and resin film and the electronic elements can be strongly attached to each other via the sealing materials 12 to ensure that the electronic elements are sealed, and it is possible to prevent penetration of water between the substrate and the sealing materials 12 and also prevent the occurrence of troubles, such as lifting and delamination, between the sealing materials 12 and the electronic elements. The upper limit of the adhesion force is not particularly restricted, but may preferably be 500 N/25 mm or less, in general.

Here, the adhesion force may be defined as a value that is measured by performing a peel test under a condition of a peel speed of 300 mm/min and a peel angle of 180° using a tensile tester (TENSILON available from ORIENTEC Co., LTD). The peel test may be performed in an environment of 23°C and 50% RH after the sealing materials 12 are attached to the glass plate and they are left in the same environment for 24 hours.

### (2) Protection Materials

The laminated sheet 1A for sealing electronic elements according to the present embodiment may have protection materials 13 at both side portions in the width direction. According to the feature that the laminated sheet 1A for sealing electronic elements has such protection materials 13, even when the laminated sheet 1A for sealing electronic elements is wound up into a roll-like shape, the winding pressure applied to the sealing materials 12 can be reduced, and it is possible to suppress the occurrence of winding traces (traces of profiles of other sealing materials 12 which are overlapped when wound up) and puckering on the sealing materials 12.

In the present embodiment, the protection materials 13 may be in a long belt-like shape, but the shape is not limited thereto. For example, the protection materials 13 may have a shape having extended parts that slot into spaces between the sealing materials 12. In an alternative embodiment, the protection materials 13 may be in belt-like shapes that are intermittently provided. It should be noted that the protection materials 13 are not essential components in the present invention and may be omitted from the laminated sheet 1A for sealing electronic elements.

The material that constitutes the protection materials 13 is not particularly limited, provided that it has the above effect. For example, the protection materials 13 may be composed of the same material as that of the sealing materials 12, or may be composed of a desired material with which coating or printing is possible, or may be composed of a desired pressure sensitive adhesive sheet that comprises a base material and a pressure sensitive adhesive layer. In consideration of simple production, it is preferred that the protection materials 13 are composed of the same material as that of the sealing materials 12 and formed concurrently with the formation of the sealing materials 12. This production method will be described later.

It is preferred that the thickness of the protection materials 13 is equal to or thicker than the thickness of the sealing materials 12. This can effectively suppress the occurrence of winding traces and puckering on the sealing materials 12.

### (3) Release Sheets

The first release sheet 11a and the second release sheet 11b are not particularly limited, provided that they can support the sealing materials 12 and can easily be removed from the sealing materials 12.

Examples of the first release sheet 11a and second release sheet 11b include polyethylene film, polypropylene film, polybutene film, polybutadiene film, polymethylpentene film, polyvinyl chloride film, vinyl chloride copolymer film, polyethylene terephthalate film, polyethylene naphthalate film, polybutylene terephthalate film, polyurethane film, ethylene-vinyl acetate film, ionomer resin film, ethylene-(meth)acrylic acid copolymer film, ethylene-(meth)acrylic ester copolymer film, polystyrene film, polycarbonate film, polyimide film, fluorine resin film, and crosslinked films thereof. Laminate film obtained by laminating a plurality of such films may also be used.

It is preferred that the surfaces of the first release sheet 11a and second release sheet 11b at the side of the sealing materials 12 are subjected to release treatment. Examples of release agent to be used for the release treatment include alkyd-based, silicone-based, fluorine-based, unsaturated polyester-based, polyolefin-based and wax-based release agents.

When the second release sheet 11b is released earlier and the first release sheet 11a is released later in the use of the laminated sheet 1A for sealing electronic elements, it is preferred that the second release sheet 11b is an easy release sheet having a smaller release force and the first release sheet 11a is a tight release sheet having a larger release force.

The thickness of the first release sheet 11a and second release sheet 11b is not particularly restricted, but may ordinarily be about 10 to 200 µm and preferably about 20 to 100 µm.

It should be noted that the second release sheet 11b is not an essential component in the present invention and may be omitted from the laminated sheet 1A for sealing electronic elements. In this case, in order that, when the laminated sheet 1A for sealing electronic elements is wound up into a roll-like shape and unreeled from the roll, the sealing materials 12 do not adhere to the back surface of the first release sheet 11a (the surface of the first release sheet 11a at the opposite side to the sealing materials 12 of the laminated sheet 1A for sealing electronic elements before being wound up), it is preferred that the back surface of the first release sheet 11a is also subjected to release treatment, or the top surfaces of the sealing materials 12 (the surfaces of the sealing materials 12 at the opposite sides to the first release sheet 11a of the laminated sheet 1A for sealing electronic elements before being wound up) are formed with irregularities to reduce the contact area between the sealing materials 12 and the back surface of the first release sheet 11a. Such irregularities on the top surfaces of the sealing materials 12 can be formed, for example, by embossing. The profile of the irregularities is not particularly limited, provided that the sealing materials 12 do not adhere to the back surface of the first release sheet 11a.

### (4) Production of Laminated Sheet for Sealing Electronic Elements

In an example of a preferred production method for the laminated sheet 1A for sealing electronic elements, a sealing material layer may first be formed on one surface of the first release sheet 11a which is a plane having releasability (release surface). The sealing material layer may have approximately the same size as that of the first release sheet 11a and comprise a material that constitutes the sealing materials 12.

The method of forming the sealing material layer may be appropriately selected in accordance with the type of material that constitutes the sealing materials 12, and examples of the method include melt extrusion method, calender method, dry method, and solution method. When the solution method is employed, coating may be performed by a known coating method using a solution in which the material that constitutes the sealing materials 12 is dissolved in an organic solvent, and the obtained coating film may be appropriately dried.

Subsequently, the sealing material layer may be half cut so that the sealing materials 12 and protection materials 13 having the previously-described shapes are formed. That is, only the sealing material layer may be cut so that the first release sheet 11a is not cut. In this operation, the first release sheet 11a may be cut in, provided that the first release sheet 11a is not fully cut. The above half-cutting may be performed using an ordinary method and can be performed, for example, using a punching apparatus or the like.

Thereafter, unnecessary portions of the sealing material layer caused by the half-cutting, specifically the portions between the sealing materials 12 and protection materials 13 and the portions between adjacent sealing materials 12, may be removed. Through this operation, a laminate may be obtained in which the sealing materials 12 and the protection materials 13 are laminated on the release surface of the first release sheet 11a.

Finally, the second release sheet 11b may be laminated on the exposed surfaces of the above sealing materials 12 and protection materials 13 (the surfaces at the opposite sides to the first release sheet 11a) so that the release surface of the second release sheet 11b comes into contact with the sealing materials 12 and the protection materials 13. The laminated sheet 1A for sealing electronic elements can thus be obtained.

In the laminated sheet 1A for sealing electronic elements obtained by the above production method, the protection materials 13 are composed of the same material as that of the sealing materials 12.

The production method for the laminated sheet 1A for sealing electronic elements is not limited to the above method. For example, another method may include coating or printing the release surface of the first release sheet 11a with the material that constitutes the sealing materials 12 so that the sealing materials 12 and protection materials 13 having the previously-described shapes are formed, and laminating the second release sheet 11b on the formed sealing materials 12 and protection materials 13. In such a method, the protection materials 13 may also be formed by coating or printing of a different material than the material that constitutes the sealing materials 12, or formed using a pressure sensitive adhesive tape or the like.

### (5) Production of Electronic Elements

There may be mentioned various methods as production methods for electronic devices using the laminated sheet 1A for sealing electronic elements, and exemplary methods include the following methods, for example.

### (5-1)

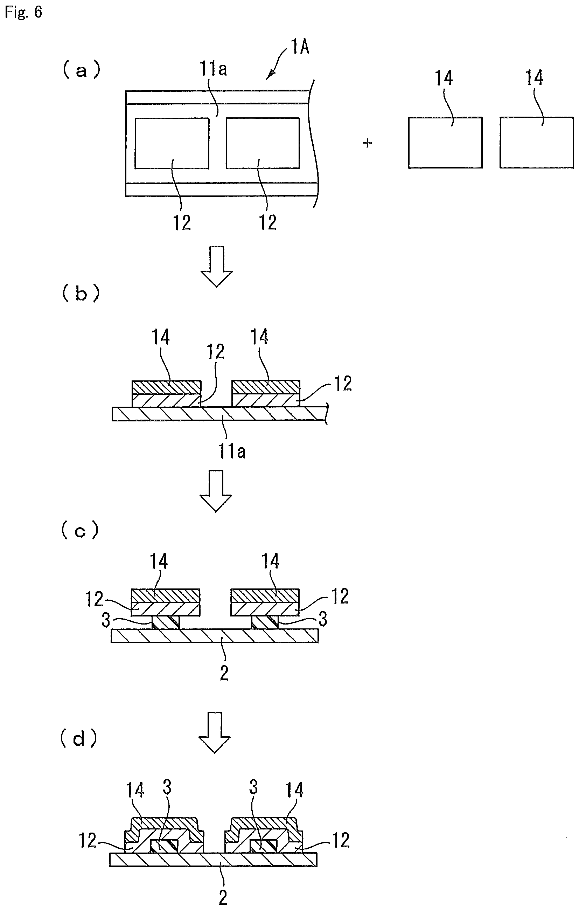

As shown in FIG. 6(a), gas barrier films 14 may be prepared in addition to the laminated sheet 1A for sealing electronic elements. The gas barrier films 14 may have a shape corresponding to that of electronic elements 3 as objects to be sealed, e.g. approximately the same shape as that of the sealing materials 12. The second release sheet 11b of the laminated sheet 1A for sealing electronic elements may be removed. Then, as shown in FIG. 6(b), the above gas barrier films 14 may be laminated on the sealing materials 12 at the opposite sides to the first release sheet 11a.

On the other hand, a substrate 2 shown in FIG. 6(c), on which a plurality of electronic elements 3 are formed, may be prepared. The substrate 2 may be a hard substrate such as glass plate, plastic plate and ceramics plate, or may also be a flexible substrate such as resin film.

As shown in FIG. 6(c), laminates of the sealing materials 12 and gas barrier films 14 may be released from the first release sheet 11a, and the above laminates may be caused to overlap the electronic elements 3 so that the sealing materials 12 come into contact with the electronic elements 3. This process can be performed using a known scheme. For example, the first release sheet 11a may be moved while being folded at a sharp angle in the vicinity above the electronic elements 3, thereby to release the above laminates from the first release sheet 11a on the electronic elements 3, and the above laminates may be pressed to the electronic elements 3 using a roller or the like so as to be caused to overlap the electronic elements 3.

Thereafter, as shown in FIG. 6(d), the electronic elements 3 may be sealed with the above laminates of the sealing materials 12 and gas barrier films 14, such as by heating/pressurizing and vacuum lamination. Finally, the substrate 2 may be divided into pieces with individual electronic elements 3. Through this operation, electronic devices can be obtained in which the electronic elements 3 are sealed with the sealing materials 12 and the gas barrier films 14.

The above sealing materials 12 and gas barrier films 14 have a shape corresponding to that of the electronic elements 3, and therefore it is not required to remove portions of the sealing materials 12 and gas barrier films 14 corresponding to the terminal parts of the electronic elements 3 so that the process can be simplified, and it is thus possible to prevent the possibility that the terminal parts of the electronic elements 3 are damaged due to work for the removal, and/or the possibility that the sealing materials 12 or the gas barrier films 14 remain at the terminal parts of the electronic elements 3. It is also possible to prevent the possibility that the sealing materials 12 and the gas barrier films 14 are damaged when the plurality of electronic elements 3 sealed on the substrate 2 is divided into individual electronic elements 3. Therefore, according to the laminated sheet 1A for sealing electronic elements of the present embodiment, highly reliable electronic devices can be produced in an efficient manner.

### (5-2)

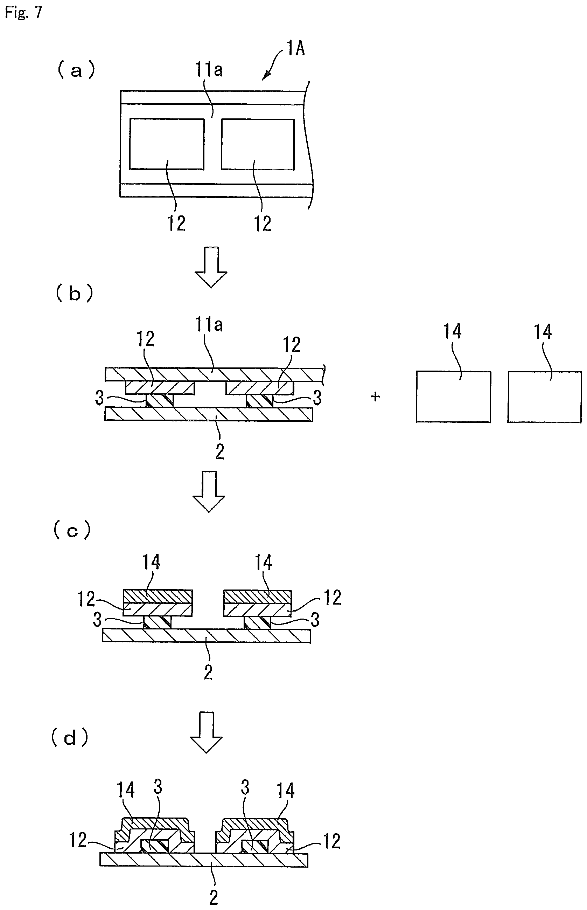

As shown in FIG. 7(a), the second release sheet 11b of the laminated sheet 1A for sealing electronic elements may be removed. Then, as shown in FIG. 7(b), a substrate 2 formed thereon with a plurality of electronic elements 3 may be prepared, and the sealing materials 12 laminated on the first release sheet 11a may be caused, in this state, to overlap the electronic elements 3. On the other hand, gas barrier films 14 may be prepared. The gas barrier films 14 may have a shape corresponding to that of electronic elements 3 as objects to be sealed.

Then, as shown in FIG. 7(c), the first release sheet 11a may be removed from the sealing materials 12, and the above gas barrier films 14 may be laminated on the exposed sealing materials 12. Thereafter, as shown in FIG. 7(d), the electronic elements 3 may be sealed with laminates of the above sealing materials 12 and gas barrier films 14, such as by heating/pressurizing and vacuum lamination. Finally, the substrate 2 may be divided into pieces with individual electronic elements 3. Through this operation, electronic devices can be obtained in which the electronic elements 3 are sealed with the sealing materials 12 and the gas barrier films 14. As in the above production method, also according to this production method, highly reliable electronic devices can be produced in an efficient manner.

In the above production method, the first release sheet 11a is removed after the sealing materials 12 are caused to overlap the electronic elements 3, but the present invention is not limited to this. The sealing materials 12 may be caused to overlap the electronic elements 3 while removing the first release sheet 11a (see the production method of (5-1)).

### (5-3)

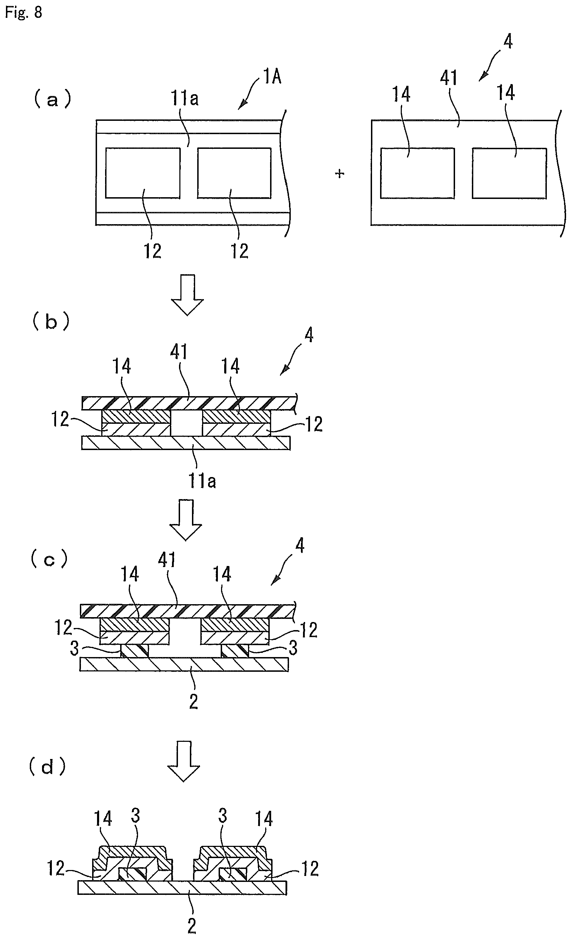

As shown in FIG. 8(a), a gas barrier film-laminated sheet 4 may be prepared in addition to the laminated sheet 1A for sealing electronic elements. The gas barrier film-laminated sheet 4 may be configured such that a plurality of gas barrier films 14 are laminated on a long support sheet 41 in the same arrangement as that of the sealing materials 12 on the first release sheet 11a of the laminated sheet 1A for sealing electronic elements. The gas barrier films 14 may have a shape corresponding to that of electronic elements 3 as objects to be sealed. The second release sheet 11b of the laminated sheet 1A for sealing electronic elements may be removed.

Then, as shown in FIG. 8(b), the sealing materials 12 on the first release sheet 11a of the laminated sheet 1A for sealing electronic elements and the gas barrier films 14 on the support sheet 41 of the gas barrier film-laminated sheet 4 may be laminated with each other.

On the other hand, a substrate 2 shown in FIG. 8(c), on which a plurality of electronic elements 3 are formed, may be prepared. Then, as shown in FIG. 8(c), the first release sheet 11a may be removed from the sealing materials 12, and laminates of the gas barrier films 14 and gas barrier films 14 on the support sheet 41 may be caused to overlap the electronic elements 3 so that the sealing materials 12 come into contact with the electronic elements 3.

Thereafter, as shown in FIG. 8(d), the electronic elements 3 may be sealed with the above laminates of the sealing materials 12 and gas barrier films 14, such as by heating/pressurizing and vacuum lamination, and the support sheet 41 may be removed from the gas barrier films 14. Finally, the substrate 2 may be divided into pieces with individual electronic elements 3. Through this operation, electronic devices can be obtained in which the electronic elements 3 are sealed with the sealing materials 12 and the gas barrier films 14. As in the above production methods, also according to this production method, highly reliable electronic devices can be produced in an efficient manner.

In the above production method, the support sheet 41 is removed from the gas barrier films 14 after sealing, but the present invention is not limited to this. The support sheet 41 may be removed from the gas barrier films 14 before sealing.

### (5-4)

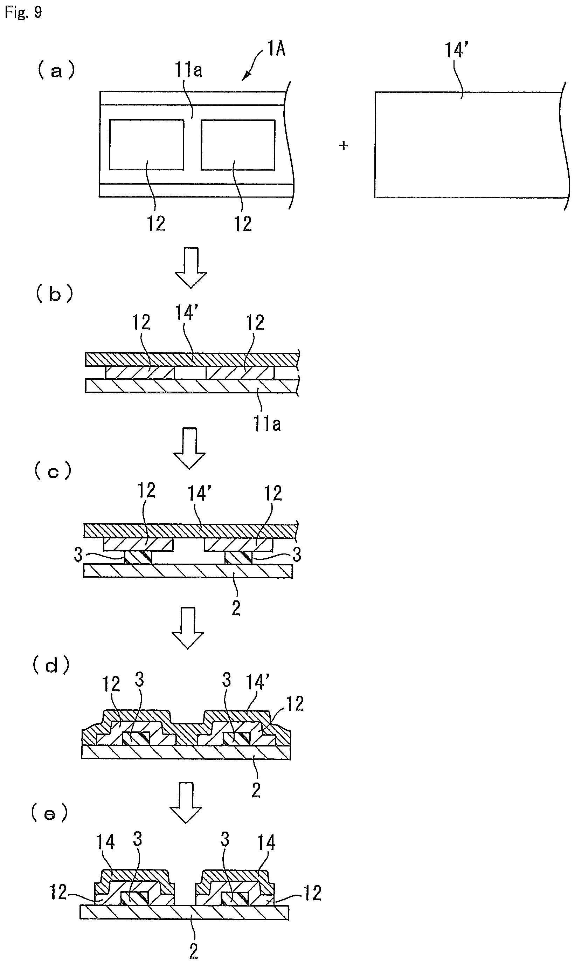

As shown in FIG. 9(a), a long gas barrier film 14' may be prepared in addition to the laminated sheet 1A for sealing electronic elements. The second release sheet 11b of the laminated sheet 1A for sealing electronic elements may be removed.

Then, as shown in FIG. 9(b), the above long gas barrier film 14' may be laminated on the sealing materials 12 on the first release sheet 11a of the laminated sheet 1A for sealing electronic elements.

On the other hand, a substrate 2 shown in FIG. 9(c), on which a plurality of electronic elements 3 are formed, may be prepared. Then, as shown in FIG. 9(c), the first release sheet 11a may be removed from the above sealing materials 12, and the sealing materials 12 on the long gas barrier film 14' may be caused to overlap the electronic elements 3.

Thereafter, as shown in FIG. 9(d), the electronic elements 3 may be sealed with a laminate of the above sealing materials 12 and long gas barrier film 14', such as by heating/pressurizing and vacuum lamination. Then, as shown in FIG. 9(e), the long gas barrier film 14' may be cut into a shape corresponding to that of the electronic elements 3, and an unnecessary portion may be removed. Finally, the substrate 2 may be divided into pieces with individual electronic elements 3. Through this operation, electronic devices can be obtained in which the electronic elements 3 are sealed with the sealing materials 12 and the gas barrier films 14.

The above sealing materials 12 have a shape corresponding to that of the electronic elements 3, and therefore it is not required to remove portions of the sealing materials 12 corresponding to the terminal parts of the electronic elements 3 so that the process can be simplified, and it is thus possible to prevent the possibility that the terminal parts of the electronic elements 3 are damaged due to work for the removal, and/or the possibility that the sealing materials 12 remain at the terminal parts of the electronic elements 3. It is also possible to prevent the possibility that the sealing materials 12 are damaged when the plurality of electronic elements 3 sealed on the substrate 2 is divided into individual electronic elements 3. Therefore, according to the laminated sheet 1A for sealing electronic elements of the present embodiment, highly reliable electronic devices can be produced in an efficient manner.

### <Second Embodiment>

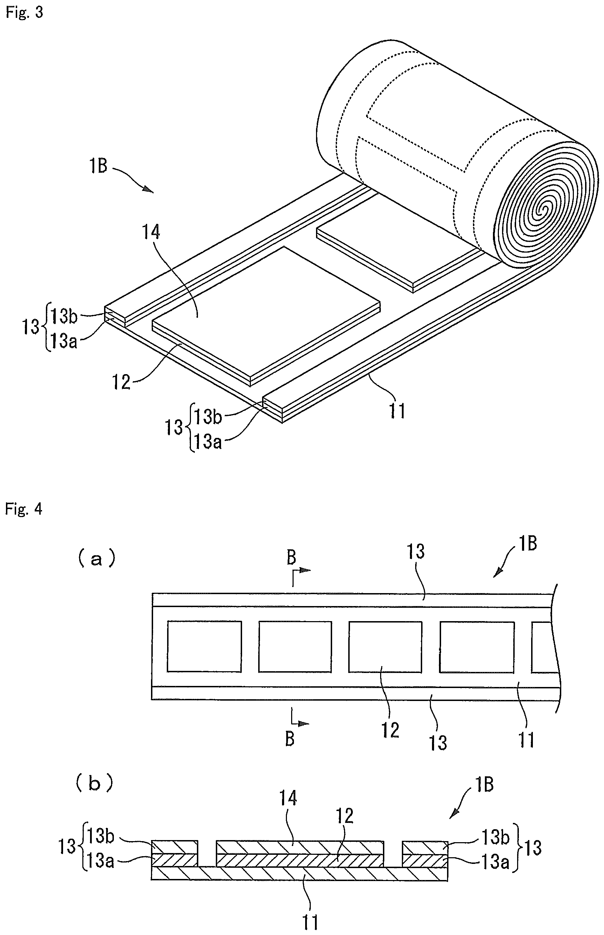

As shown in FIG. 3 and FIG. 4, the laminated sheet 1B for sealing electronic elements according to a second embodiment of the present invention may be configured to comprise: a long release sheet 11; a plurality of sealing materials 12 that are laminated on the release sheet 11 within a central area in the width direction and at different positions in the longitudinal direction; gas barrier films 14 that are laminated on the sealing materials at the opposite sides to the release sheet 11; and protection materials 13 that are laminated on the release sheet 11 at both side portions in the width direction.

The laminated sheet 1B for sealing electronic elements according to the present embodiment is long, and may usually be wound up into a roll-like shape and used while being unreeled from the roll (see FIG. 3).

The release sheet 11 and sealing materials 12 of the laminated sheet 1B for sealing electronic elements according to the present embodiment have the same structures as those of the first release sheet 11a and sealing materials 12, respectively, of the previously-described laminated sheet 1A for sealing electronic elements.

### (1) Gas Barrier Films

The gas barrier films 14 are for giving gas barrier properties to the obtained electronic device and for preventing/suppressing gases from reaching the electronic elements. The types of gases to be kept away may be determined in accordance with the type of electronic elements. For various electronic elements, it is preferred to keep out moisture.

In the present embodiment, the gas barrier films 14 may have approximately the same size and shape as those of the sealing materials 12. Note, however, that the gas barrier films 14 are not limited to the above and may be sufficient if they have a size and shape with which the gas barrier properties can be normally exhibited. For example, the gas barrier films 14 may be formed slightly larger than the sealing materials 12.

The structure of the gas barrier films 14 is not particularly limited and may be, for example, a structure in which a gas barrier layer is formed directly or via another layer on either surface or on each of both surfaces of a base film, a structure in which a gas barrier layer is provided at the middle of a base film, or the like. Among them, the structure in which a gas barrier layer is formed directly or via another layer on either surface or on each of both surfaces of a base film may be preferred as the structure of the gas barrier films 14.

Examples of the base film to be used include, but are not particularly limited to, resin films formed of polyolefin such as cycloolefin-based resin, polyethylene, polypropylene, ethylene-(meth)acrylic acid copolymer and ethylene-(meth)acrylic ester copolymer, polyester such as polyethylene terephthalate and polybutylene terephthalate, or other resin such as polyvinyl chloride, polystyrene, polyurethane, polycarbonate, polyamide, polyimide, polyamideimide, polysulfone, polyethersulfone, polyphenylenesulfide, polyacrylate, acrylic-based resin, polybutene, polybutadiene, polymethylpentene, ethylene-vinyl acetate copolymer, ABS resin and ionomer resin, and laminate films thereof. The base film may be a stretched film or may also be an unstretched film. The base film may contain various additives such as ultraviolet absorber.

The material of the above gas barrier layer may be sufficient if it can suppress transmission of gas (moisture vapor), and examples thereof include metals such as aluminum, magnesium, zinc and tin, silicon compounds such as silicon nitride, silicon oxide, silicon oxynitride, polysilazane compound, polycarbosilane compound, polysilane compound, polyorganosiloxane compound and tetraorganosilane compound, aluminum compounds such as aluminum oxide and aluminum oxynitride, inorganic oxides such as magnesium oxide, zinc oxide, indium oxide and tin oxide, and resins such as polyvinyl alcohol, ethylene-vinyl alcohol copolymer, polyvinyl chloride, polyvinylidene chloride and polychlorotrifluoroethylene. One type of the above material may be used alone, or two or more types may be used in combination. The gas barrier layer may comprise a single layer or multiple layers. When the gas barrier layer comprises multiple layers, they may be formed of different materials.

The thickness of the gas barrier films 14 is not particularly restricted, but may preferably be 0.5 to 500 µm, more preferably 1 to 200 µm, and further preferably 5 to 100 µm, in view of easy handling.

As shown in FIG. 5, the plurality of laminates of the sealing materials 12 and gas barrier films 14 may be provided not only at positions in the longitudinal direction of the laminated sheet 1B for sealing electronic elements but also at positions in the width direction.

Here, the laminates of the sealing materials 12 and gas barrier films 14 may preferably have a moisture vapor transmission rate W (JIS K7129A method) preferably of 20 g/(m²·day) or less, particularly preferably of 15 g/(m²·day) or less, and further preferably of 10 g/(m²·day) or less, under an environment of a temperature of 40°C and a relative humidity of 90% RH in terms of a thickness of 50 µm (i.e., when the thickness of the laminates is 50 µm). According to the feature that the moisture vapor transmission rate W is within the above range, when the electronic elements are sealed, the external moisture vapor can be effectively blocked at the above laminates so as to be prevented/suppressed from reaching the electronic elements, which are thus less likely to be negatively affected by the moisture.

### (2) Protection Materials

As an example, the protection materials 13 of the present embodiment may be each configured such that a first protection member 13a and a second protection member 13b are laminated with each other, but are not limited thereto. For example, each of the protection materials 13 may comprise a single layer or may also comprise two layers of a base material and a pressure sensitive adhesive layer. In the present embodiment, the first protection member 13a may preferably be composed of the same material as that of the sealing materials 12, and the second protection member 13b may preferably be composed of the same material as that of the gas barrier films 14. This allows easy production of the laminated sheet 1B for sealing electronic elements through the method to be described later.

As in the laminated sheet 1A for sealing electronic elements, also in the laminated sheet 1B for sealing electronic elements, the protection materials 13 are not essential components and may be omitted from the laminated sheet 1B for sealing electronic elements.

### (3) Production of Laminated Sheet for Sealing Electronic Elements

In an example of a preferred production method for the laminated sheet 1B for sealing electronic elements, a sealing material layer and a gas barrier material layer may first be formed on one surface of the release sheet 11 which is a plane having releasability (release surface) so that the sealing material layer and the gas barrier material layer are laminated in this order. The sealing material layer and the gas barrier material layer may have approximately the same size as that of the release sheet 11. The sealing material layer may comprise a material that constitutes the sealing materials 12. The gas barrier material layer may comprise a material that constitutes the gas barrier films 14.

The sealing material layer and the gas barrier material layer may be formed by coextrusion molding. In an alternative embodiment, the sealing material layer may be formed by the same method as described in the production method for the laminated sheet 1A for sealing electronic elements, and thereafter the gas barrier material layer may be formed by the same method, or a gas barrier material layer which has been preliminarily formed in a long film-like shape may be laminated.

Subsequently, the gas barrier material layer and the sealing material layer may be half cut so as to form the laminates of the sealing materials 12 and gas barrier films 14 having the previously-described shape and the protection materials 13 (laminates of the first protection members 13a and the second protection members 13b). That is, only the gas barrier material layer and the sealing material layer may be cut so that the release sheet 11 is not cut. In this operation, the release sheet 11 may be cut in, provided that the release sheet 11 is not fully cut.

Thereafter, unnecessary portions of the gas barrier material layer and sealing material layer caused by the half-cutting, specifically the portions between the laminates of the sealing materials 12 and gas barrier films 14 and the protection materials 13 and the portions between adjacent laminates of the gas barrier films 14 and sealing materials 12, may be removed. Through this operation, the laminated sheet 1B for sealing electronic elements may be obtained in which the laminates of the sealing materials 12 and gas barrier films 14 and the protection materials 13 are laminated on the release surface of the release sheet 11a. Again, the protection materials 13 may be laminates of the first protection members 13a the second protection members 13b.

In the laminated sheet 1B for sealing electronic elements obtained by the above production method, the first protection members 13a are composed of the same material as that of the sealing materials 12, and the second protection members 13b are composed of the same material as that of the gas barrier films 14.

The production method for the laminated sheet 1B for sealing electronic elements is not limited to the above method. For example, another method may include coating or printing the release surface of the release sheet 11 with the material that constitutes the sealing materials 12 so that the sealing materials 12 and first protection members 13a having the previously-described shape are formed, and thereafter coating or printing these sealing materials 12 and first protection members 13a with the material that constitutes the gas barrier films 14, or attaching films that constitute the gas barrier films 14 to these sealing materials 12 and first protection members 13a. In such a method, the protection materials 13 may also be formed by coating or printing of different materials than the materials that constitute the sealing materials 12 and the gas barrier films 14. Still another method may include coating or printing the release surface of the release sheet 11 with the material that constitutes the sealing materials 12 so that the sealing materials 12 having the previously-described shape are formed, while coating or printing the release surface of the release sheet 11 with a desired material so that the protection materials 13 having the previously-described shape are formed, or attaching a pressure sensitive adhesive tape.

### (4) Production of Electronic Elements

The following method may be exemplified, for example, as a production method for electronic devices using the laminated sheet 1B for sealing electronic elements.

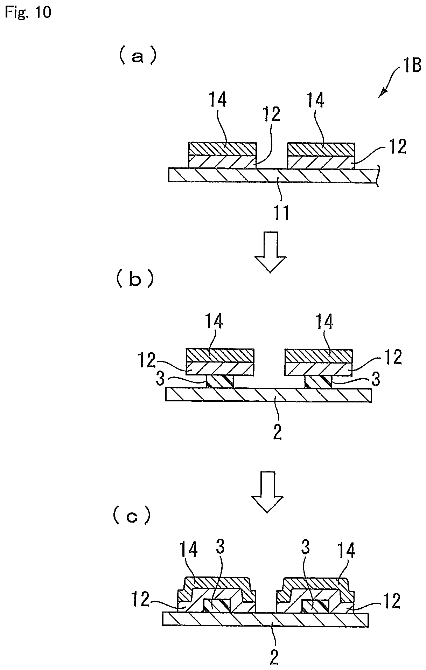

As shown in FIG. 10(a), the laminated sheet 1B for sealing electronic elements may be prepared, and a substrate 2 shown in FIG. 10(b), on which a plurality of electronic elements 3 are formed, may be prepared. Then, as shown in FIG. 10(b), laminates of the sealing materials 12 and gas barrier films 14 may be released from the release sheet 11, and the above laminates may be caused to overlap the electronic elements 3 so that the sealing materials 12 come into contact with the electronic elements 3.

Subsequently, as shown in FIG. 10(c), the electronic elements 3 may be sealed with the above laminates of the sealing materials 12 and gas barrier films 14, such as by heating/pressurizing and vacuum lamination. Finally, the substrate 2 may be divided into pieces with individual electronic elements 3. Through this operation, electronic devices can be obtained in which the electronic elements 3 are sealed with the sealing materials 12 and the gas barrier films 14.

The above sealing materials 12 and gas barrier films 14 have a shape corresponding to that of the electronic elements 3, and therefore it is not required to remove portions of the sealing materials 12 and gas barrier films 14 corresponding to the terminal parts of the electronic elements 3 so that the process can be simplified, and it is thus possible to prevent the possibility that the terminal parts of the electronic elements 3 are damaged due to work for the removal, and/or the possibility that the sealing materials 12 or the gas barrier films 14 remain at the terminal parts of the electronic elements 3. It is also possible to prevent the possibility that the sealing materials 12 and the gas barrier films 14 are damaged when the plurality of electronic elements 3 sealed on the substrate 2 is divided into individual electronic elements 3. Moreover, in the laminated sheet 1B for sealing electronic elements, the gas barrier films 14 or the long gas barrier film 14' as in the laminated sheet 1A for sealing electronic elements need not be separately prepared. Therefore, according to the laminated sheet 1B for sealing electronic elements of the present embodiment, highly reliable electronic devices can be produced in a considerably efficient manner.

The laminated sheets 1A and 1B for sealing electronic elements as described above can be applied to production of electronic device, such as modules for display devices and solar cell modules, in which electronic elements are sealed, and can also be applied to flexible electronic devices that use resin films as substrates on which electronic elements are formed.

It should be appreciated that the embodiments heretofore explained are described to facilitate understanding of the present invention and are not described to limit the present invention. Therefore, it is intended that the elements disclosed in the above embodiments include all design changes and equivalents to fall within the technical scope of the present invention.

### [Industrial Applicability]

The laminated sheet for sealing electronic elements and the production method for electronic devices according to the present invention may be suitable, for example, for producing modules for display devices in which organic EL elements and the like are sealed.

### [Description of Reference Numerals]

- 1A, 1B...: Laminated sheet for sealing electronic elements
11... Release sheet
11a... First release sheet
11b... Second release sheet
12... Sealing material
13... Protection material
13a... First protection member
13b... Second protection member
14... Gas barrier film
14'... Long gas barrier film
- 2...: Substrate
- 3...: Electronic element
- 4...: Gas barrier film-laminated sheet
41... Support sheet

## Claims

1. A laminated sheet for sealing electronic elements, the laminated sheet comprising:
a long release sheet; and
a plurality of sealing materials laminated on the long release sheet at different positions, the sealing materials having a shape corresponding to that of the electronic elements as objects to be sealed.

2. The laminated sheet for sealing electronic elements as recited in claim 1, wherein protection materials are provided at both side portions in a width direction of the long release sheet,
wherein the sealing materials are provided on the long release sheet at different positions than those of the protection materials.

3. The laminated sheet for sealing electronic elements as recited in claim 2, wherein the protection materials have a thickness that is equal to or thicker than a thickness of the sealing materials.

4. The laminated sheet for sealing electronic elements as recited in claim 2, wherein the protection materials are composed of the same material as that of the sealing materials.

5. The laminated sheet for sealing electronic elements as recited in claim 1, wherein gas barrier films are laminated on the sealing materials at opposite sides to the release sheet, wherein the gas barrier films have a shape corresponding to that of the electronic elements as objects to be sealed.

6. The laminated sheet for sealing electronic elements as recited in claim 5, wherein protection materials are provided at both side portions in a width direction of the long release sheet, wherein laminates of the sealing materials and the gas barrier films are provided on the long release sheet at different positions than those of the protection materials.

7. The laminated sheet for sealing electronic elements as recited in claim 6, wherein the protection materials have a thickness that is equal to or thicker than a thickness of the laminates of the sealing materials and the gas barrier films.

8. The laminated sheet for sealing electronic elements as recited in claim 6, wherein the protection materials are composed of the same materials as those of the laminates of the sealing materials and the gas barrier films.

9. The laminated sheet for sealing electronic elements as recited in claim 1, wherein a second long release sheet is laminated on the sealing materials at opposite sides to the release sheet.

10. The laminated sheet for sealing electronic elements as recited in claim 1, wherein the plurality of sealing materials are provided at positions at least in a longitudinal direction of the long release sheet.

11. The laminated sheet for sealing electronic elements as recited in claim 10, wherein the plurality of sealing materials are provided at positions also in a width direction of the long release sheet.

12. The laminated sheet for sealing electronic elements as recited in claim 1, wherein the electronic elements as objects to be sealed are organic EL elements.

13. The laminated sheet for sealing electronic elements as recited in claim 1, wherein the sealing materials are composed of at least one type selected from the group consisting of acid-modified polyolefin-based resin, silane-modified polyolefin-based resin, ionomer, ethylene-(meth)acrylic acid copolymer, and rubber-based resin.

14. The laminated sheet for sealing electronic elements as recited in claim 1, wherein laminates of the sealing materials and gas barrier films have a moisture vapor transmission rate of 20 g/(m²·day) or less under an environment of a temperature of 40°C and a relative humidity of 90% RH in terms of a thickness of 50 µm.

15. A production method for the laminated sheet for sealing electronic elements as recited in claim 4, the production method comprising:
forming a sealing material layer on one surface of the long release sheet, the sealing material layer having approximately the same size as that of the release sheet and comprising a material that constitutes the sealing materials; and
half cutting the sealing material layer to remove an unnecessary portion so that the sealing materials and the protection materials are formed.

16. A production method for the laminated sheet for sealing electronic elements as recited in claim 8, the production method comprising:
forming a sealing material layer and a gas barrier material layer on one surface of the long release sheet so that the sealing material layer and the gas barrier material layer are laminated in this order, the sealing material layer and the gas barrier material layer having approximately the same size as that of the release sheet, the sealing material layer comprising a material that constitutes the sealing materials, the gas barrier material layer comprising a material that constitutes the gas barrier films; and
half cutting the gas barrier material layer and the sealing material layer to remove an unnecessary portion so that the laminates of the sealing materials and the gas barrier films and the protection materials are formed.

17. A production method for electronic devices, comprising:
laminating gas barrier films on the sealing materials of the laminated sheet for sealing electronic elements as recited in any one of claims 1 to 4 at opposite sides to the release sheet, the gas barrier films having a shape corresponding to that of the electronic elements as objects to be sealed;
releasing laminates of the sealing materials and the gas barrier films from the release sheet; and
causing the laminates of the sealing materials and the gas barrier films to overlap the electronic elements as objects to be sealed so that the sealing materials come into contact with the electronic elements and sealing the electronic elements.

18. A production method for electronic devices, comprising:
causing the sealing materials of the laminated sheet for sealing electronic elements as recited in any one of claims 1 to 4 to overlap the electronic elements as objects to be sealed;
removing the release sheet from the sealing materials at any stage;
laminating gas barrier films on the sealing materials at opposite sides to the electronic elements, the gas barrier films having a shape corresponding to that of the electronic elements as objects to be sealed; and
sealing the electronic elements.

19. A production method for electronic devices, comprising:
preparing a gas barrier film-laminated sheet configured such that a plurality of gas barrier films are laminated on a long support sheet in the same arrangement as that of the sealing materials on the long release sheet of the laminated sheet for sealing electronic elements as recited in any one of claims 1 to 4, the gas barrier films having a shape corresponding to that of the electronic elements as objects to be sealed;
laminating the sealing materials on the long release sheet of the laminated sheet for sealing electronic elements and the gas barrier films on the long support sheet of the gas barrier film-laminated sheet with each other;
removing the release sheet from the sealing materials;
causing laminates of the gas barrier films and the sealing materials on the support sheet to overlap the electronic elements as objects to be sealed so that the sealing materials come into contact with the electronic elements and sealing the electronic elements; and
removing the support sheet from the gas barrier films at any stage.

20. A production method for electronic devices, comprising:
laminating a long gas barrier film on the sealing materials of the laminated sheet for sealing electronic elements as recited in any one of claims 1 to 4 at opposite sides to the release sheet;
removing the release sheet from the sealing materials;
causing the sealing materials on the long gas barrier film to overlap the electronic elements and sealing the electronic elements; and
cutting the long gas barrier film into a shape corresponding to that of the electronic elements and removing an unnecessary portion.

21. A production method for electronic devices, comprising:
releasing laminates of the sealing materials and the gas barrier films of the laminated sheet for sealing electronic elements as recited in any one of claims 5 to 8 from the release sheet; and
causing the laminates of the sealing materials and the gas barrier films to overlap the electronic elements as objects to be sealed so that the sealing materials come into contact with the electronic elements and sealing the electronic elements.
